# EUROPEAN PATENT APPLICATION

(11) **EP 2 846 367 A1**
(43) Date of publication of application: **11.03.2015**
(21) Application number: 14157438.4
(22) Date of filing: 03.03.2014
(51) Int. Cl.: H01L 33/50, H01L 33/00, H01L 33/44, H01L 33/38, H01L 33/48

(54) **Semiconductor light emitting device and method for manufacturing same**

(30) Priority: 06.09.2013 JP 2013184846
(71) Applicant: Kabushiki Kaisha Toshiba, Tokyo 105-8001 (JP)
(72) Inventor: Akimoto, Yosuke, Minato-ku, Tokyo 105-8001 (JP); Kojima, Akihiro, Minato-ku, Tokyo 105-8001 (JP); Shimada, Miyoko, Minato-ku, Tokyo 105-8001 (JP); Tomizawa, Hideyuki, Minato-ku, Tokyo 105-8001 (JP); Sugizaki, Yoshiaki, Minato-ku, Tokyo 105-8001 (JP); Furuyama, Hideto, Minato-ku, Tokyo 105-8001 (JP)
(74) Representative: Hoffmann Eitle

(57) **Abstract**

A semiconductor light emitting device (1, 2, 3, 4, 5, 6) according to an embodiment includes a semiconductor layer (10), a first resin layer (21) provided on the semiconductor layer (10), first fluorescer particles (22) disposed in the first resin layer (21), and a second resin layer (23) provided on the first resin layer (21) to contact the first resin layer (21). Recesses (21c) are made in a surface (21a) of the first resin layer (21) contacting the second resin layer (23). The recesses (21c) are filled with portions of the second resin layer (23).

## Description

### FIELD

Embodiments described herein relate generally to a semiconductor light emitting device and a method for manufacturing the same.

### BACKGROUND

Conventionally, a method for manufacturing a semiconductor light emitting device has been proposed in which a semiconductor layer is grown by crystal growth on a wafer; electrodes are formed on the semiconductor layer; sealing with a resin body is performed; subsequently, the wafer is removed; a fluorescer layer is formed on the exposed surface of the semiconductor layer; and singulation is performed. According to such a method, fine structural bodies that are formed on the wafer can be packaged as-is; and fine semiconductor light emitting devices can be efficiently manufactured.

### BRIEF DESCRIPTION OF THE DRAWINGS

FIG. 1A is a cross-sectional view showing a semiconductor light emitting device according to a first embodiment; and FIG. 1B is a partially-enlarged cross-sectional view showing region A shown in FIG. 1A;
FIGS. 2A to 2C are partial cross-sectional views showing a method for manufacturing the semiconductor light emitting device according to the first embodiment;
FIG. 3 is a partial cross-sectional view showing a semiconductor light emitting device according to a second embodiment;
FIG. 4 is a partial cross-sectional view showing a semiconductor light emitting device according to a third embodiment;
FIG. 5 is a partial cross-sectional view showing a semiconductor light emitting device according to a fourth embodiment;
FIG. 6 is a cross-sectional view showing a semiconductor light emitting device according to a fifth embodiment; and
FIG. 7 is a cross-sectional view showing a semiconductor light emitting device according to a sixth embodiment.

### DETAILED DESCRIPTION

A semiconductor light emitting device according to an embodiment includes a semiconductor layer, a first resin layer provided on the semiconductor layer, first fluorescer particles disposed in the first resin layer, and a second resin layer provided on the first resin layer to contact the first resin layer. Recesses are made in a surface of the first resin layer contacting the second resin layer. The recesses are filled with portions of the second resin layer.

A method for manufacturing a semiconductor light emitting device according to an embodiment includes forming a first resin layer on a semiconductor layer. The first resin layer has first fluorescer particles. The method includes making recesses by removing an upper portion of the first resin layer to cause some of the first fluorescer particles to drop out from the first resin layer. The method includes forming a second resin layer on the first resin layer. Portions of the second resin layer enter the recesses.

Embodiments of the invention will now be described with reference to the drawings.

### (First embodiment)

First, a first embodiment will be described.

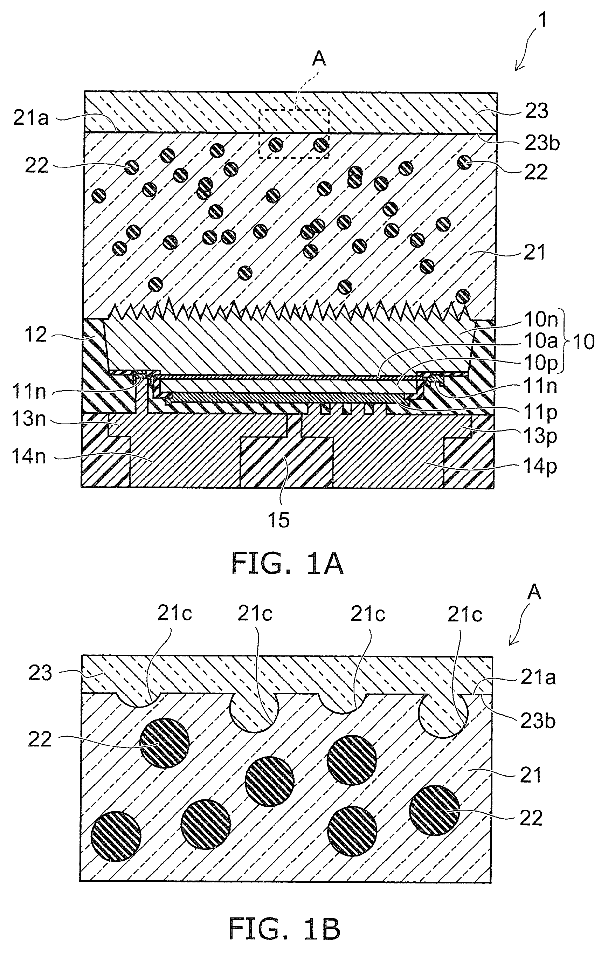

FIG. 1A is a cross-sectional view showing a semiconductor light emitting device according to the embodiment; and FIG. 1B is a partially-enlarged cross-sectional view showing region A shown in FIG. 1A.

As shown in FIG. 1A, the configuration of the entire semiconductor light emitting device 1 according to the embodiment is a rectangular parallelepiped. A semiconductor layer 10 is provided in the semiconductor light emitting device 1. The semiconductor layer 10 is formed of a compound semiconductor including, for example, gallium nitride (GaN) and is an LED (Light Emitting Diode) layer in which a p-type clad layer 10p, an active layer 10a, and an n-type clad layer 10n are stacked in order from the lower layer side. As viewed in the thickness direction, the configuration of the semiconductor layer 10 is a rectangle; and at the four corners of the rectangle, the p-type clad layer 10p and the active layer 10a are removed, and the n-type clad layer 10n is exposed at the lower surface of the semiconductor layer 10.

An area of the lower surface of the semiconductor layer 10, where the n-type clad layer 10n is exposed, is a non-emitting region, because the p-type clad layer 10p and the active layer 10a are removed. While an area of the lower surface of the semiconductor layer 10, where the p-type clad layer 10p is exposed, is a light emitting region. The non-emitting region is smaller than the light emitting region.

Also, a fine unevenness that has a period that is about the same as the wavelength of the light emitted by the semiconductor layer 10 is formed in the upper surface of the semiconductor layer 10. An emission light from the semiconductor layer 10 is emitted primarily from the upper surface of the semiconductor layer 10. An n-side electrode 11n and a p-side electrode 11p are provided on the lower surface of the semiconductor layer 10. The n-side electrode 11n is connected to the n-type clad layer 10n of the semiconductor layer 10; and the p-side electrode 11p is connected to the p-type clad layer 10p of the semiconductor layer 10. That is, the n-side electrode 11n is connected to the non-emitting region of the semiconductor layer 10, and the p-side electrode 11p is connected to the light emitting region of the semiconductor layer 10. A sealing member 12 is provided to cover the lower surface and side surface of a structural body that is made of the semiconductor layer 10, the n-side electrode 11n, and the p-side electrode 11p.

An interconnect layer 13n is provided below the n-side electrode 11n; and an n-side pillar 14n is provided under the interconnect layer 13n. The n-side pillar 14n is connected to the n-side electrode 11n via the interconnect layer 13n. The interconnect layer 13n and the n-side pillar 14n consist an n-side extraction electrode. The n-side extraction electrode is connected to the non-emitting region of the semiconductor layer 10 and extends to the light emitting region side of the semiconductor layer 10. An interconnect layer 13p is provided below the p-side electrode 11p; and a p-side pillar 14p is provided under the interconnect layer 13p. The p-side pillar 14p is connected to the p-side electrode 11p via the interconnect layer 13p. The interconnect layer 13p and the p-side pillar 14p consist a p-side extraction electrode.

A sealing member 15 that is made of, for example, a black resin material is provided to cover the interconnect layers 13n and 13p, the n-side pillar 14n, and the p-side pillar 14p. The lower surface of the n-side pillar 14n and the lower surface of the p-side pillar 14p are exposed at the lower surface of the sealing member 15. The lower surface of the n-side pillar 14n and the lower surface of the p-side pillar 14p are substantially coplanar with the lower surface of the sealing member 15.

The sealing member 15 and the sealing member 12 consists an insulating film. A first portion of the insulating film which is located lower than the lower surface of the semiconductor layer 10 supports the semiconductor layer 10 with the n-side extraction electrode and the p-side extraction electrode. A second portion of the insulating film which is located upper than the lower surface of the semiconductor layer 10 surrounds a periphery of the semiconductor layer 10.

In explanation of Fig. 1, the direction which goes to the semiconductor layer 10 from the sealing member 15 is made into the "upper", and the opposite direction is made into the "lower". However, this naming is expedient and unrelated to the direction of gravity. In explanation of the manufacture method mentioned later, the upper-and-lower notation is reversed to the middle.

A resin layer 21 is provided above the semiconductor layer 10 and above the sealing member 12 positioned at the side of the semiconductor layer 10. The resin layer 21 is formed of a resin material that is transparent or semi-transparent and is formed of, for example, a silicone resin. Many fluorescer particles 22 are dispersed in the resin layer 21. The fluorescer particles 22 are particles that absorb light of a first color emitted from the semiconductor layer 10 to emit light of a second color. For convenience of illustration, the fluorescer particles 22 are illustrated in FIG. 1A as being larger than the actual particles.

A resin layer 23 is provided on the resin layer 21. The resin layer 23 is formed of a resin material that is transparent or semi-transparent and is a layer that selectively reflects or scatters light of a designated color and transmits light of other colors. A lower surface 23b of the resin layer 23 contacts an upper surface 21a of the resin layer 21.

Then, as shown in FIG. 1B, many recesses 21c are made in the upper surface 21a of the resin layer 21. The recesses 21c are filled with a portion of the resin layer 23.

The sizes of the recesses 21c are about the same as the sizes of the fluorescer particles 22. In other words, the sizes of the recesses 21c are sizes into which the fluorescer particles 22 can fit. Some of the recesses 21c have dish-like configurations; and the diameter of the opening, i.e., the upper end portion, of such a configuration is the maximum diameter of the recess 21c. Other recesses 21c have pot-like configurations; and for such a configuration, the maximum diameter is larger than the diameter of the opening. The distribution of the maximum diameters of the recesses 21c having the pot-like configurations substantially matches the distribution of the diameters of the fluorescer particles 22. Therefore, the maximum diameter of at least one recess 21c is within the range of the distribution of the diameters of the fluorescer particles 22. On the other hand, the distribution of the maximum diameters of the recesses 21c having the dish-like configurations is shifted from the distribution of the diameters of the fluorescer particles 22 toward the smaller side. Accordingly, the distribution of the maximum diameters of the recesses 21c spreads in a range that is about the same as or less than the distribution of the diameters of the fluorescer particles 22.

The average of the diameters of the fluorescer particles 22 is, for example, about 15 µm. The distribution of the diameters of the fluorescer particles is, for example, not less than 0.1*d* and not more than 2d, where the average diameter of the fluorescer particles is d. Also, the average diameter d of the fluorescer particles can be defined as, for example, a particle diameter D50 having a volumetric basis. The particle diameter D50 is a volumetric median where the cumulative volume is 50%. In such a case, the maximum diameter of at least one recess 21c is within a range that is not less than 0.1×*D50* and not more than 2×*D50.* Other than the volumetric basis, the value of the particle diameter D50 may be calculated using a weight basis or a particle count basis.

A method for manufacturing the semiconductor light emitting device according to the embodiment will now be described.

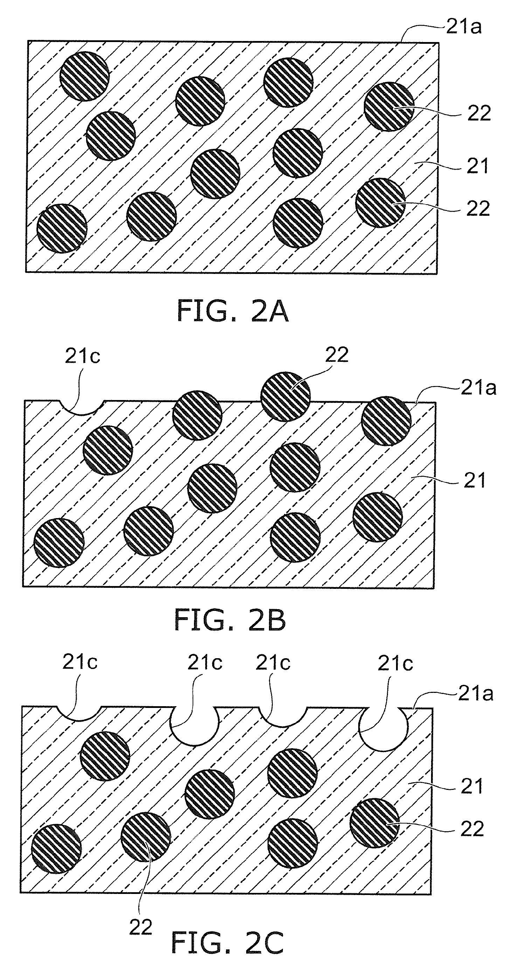

FIGS. 2A to 2C are partial cross-sectional views showing the method for manufacturing the semiconductor light emitting device according to the embodiment.

Only the resin layer 21 and the fluorescer particles 22 are shown for convenience of illustration in FIGS. 2A to 2C.

First, as shown in FIG. 1A, the semiconductor layer 10 is grown by epitaxial growth on a substrate (not shown) for crystal growth; and the semiconductor layer 10 is partitioned by being selectively removed. Then, the n-side electrode 11n and the p-side electrode 11p are formed; and the sealing member 12 is formed to bury the semiconductor layer 10, the n-side electrode 11n, and the p-side electrode 11p. Continuing, the interconnect layers 13n and 13p are formed on the sealing member 12; the n-side pillar 14n and the p-side pillar 14p are formed; and the sealing member 15 is formed to bury these components. Then, the semiconductor layer 10 is exposed by removing the substrate for crystal growth; and an unevenness is formed in the exposed surface of the semiconductor layer 10.

Then, as shown in FIG. 1A and FIG. 2A, the resin layer 21 that contains many fluorescer particles 22 is formed above the semiconductor layer 10 and above the sealing member 12, that is, on the side of the sealing member 12 where the substrate for crystal growth was provided. At this time, the surfaces of the fluorescer particles 22 are covered with the resin layer 21; and the fluorescer particles 22 are not exposed at the upper surface 21a of the resin layer 21.

Continuing as shown in FIG. 2B, the upper portion of the resin layer 21 is removed by performing, for example, machining of the upper surface 21a of the resin layer 21. Thereby, some of the fluorescer particles 22 are exposed.

Then, as shown in FIG. 2C, the machining is continued further. Thereby, the exposed fluorescer particles 22 drop out from the resin layer 21; and the recesses 21c are made where the fluorescer particles 22 dropped out. At this time, the exposed fluorescer particles 22 can be caused to drop out more reliably by appropriately selecting the conditions and tools of the machining. For example, the fluorescer particles 22 can be pulled out from the resin layer 21 by the tool catching on the exposed portions of the fluorescer particles 22 that are partially exposed from the resin layer 21. Thus, the recesses 21c having the pot-like configurations are made. Or, ultrasonic cleaning may be performed to forcibly push out the fluorescer particles 22 that are partially exposed from the resin layer 21.

Continuing as shown in FIGS. 1A and 1B, the resin layer 23 is formed on the resin layer 21 by coating a resin material. At this time, the resin material of the resin layer 23 also enters the recesses 21c of the resin layer 21 to fill the recesses 21c. Then, to adjust the chromaticity of the light emitted by the semiconductor light emitting device 1, machining of the upper surface of the resin layer 23 is performed to adjust the thickness of the resin layer 23. Thus, the semiconductor light emitting device 1 according to the embodiment is manufactured. In this way, the semiconductor light emitting device 1 has a wafer-level package structure.

Operations of the semiconductor light emitting device 1 according to the embodiment will now be described.

In the semiconductor light emitting device 1, the semiconductor layer 10 emits, for example, blue light when a voltage is applied between the p-side pillar 14p and the n-side pillar 14n. The fluorescer particles 22 that are disposed inside the resin layer 21 absorb a portion of the light emitted from the semiconductor layer 10 and emit, for example, yellow light. The remainder of the light emitted from the semiconductor layer 10 passes through the resin layer 21. Thereby, the light that is emitted by the semiconductor light emitting device 1 is white because the blue light and the yellow light are emitted outside the semiconductor light emitting device 1.

At this time, the wavelength of the light emitted by the semiconductor layer 10 fluctuates due to the process conditions, etc. Therefore, the intensity of the light emitted by the fluorescer particles 22 also fluctuates. Thereby, the chromaticity of the light emitted by the semiconductor light emitting device 1 undesirably fluctuates. Therefore, in the embodiment, the chromaticity of the light emitted by the semiconductor light emitting device 1 is adjusted by providing the resin layer 23 and adjusting the thickness of the resin layer 23. The resin layer 23 reflects or scatters the light emitted from the semiconductor layer 10 or the light emitted from the fluorescer particles 22.

Effects of the embodiment will now be described.

In the embodiment, many recesses 21c are made in the upper surface 21a of the resin layer 21; and the resin layer 23 enters the interiors of the recesses 21c. Therefore, the adhesion between the resin layer 21 and the resin layer 23 is high due to an anchor effect. Thereby, the resin layer 21 does not peel easily from the resin layer 23; and discrepancies such as peeling, etc., do not occur easily. As a result, the reliability of the semiconductor light emitting device 1 is high.

The contact surface area between the resin layer 21 and the resin layer 23 is large because the resin layer 23 enters the recesses 21c. Therefore, the transmission efficiency of the light from the resin layer 21 into the resin layer 23 is high; and the light extraction efficiency is high. Further, because an uneven structure is formed at the interface between the resin layer 21 and the resin layer 23, the total internal reflection component of the light at the interface is reduced. As a result, the transmission efficiency of the light between the resin layer 21 and the resin layer 23 is high.

In the embodiment, the recesses 21c are made in the upper surface 21a of the resin layer 21 by removing the upper portion of the resin layer 21 to expose some of the fluorescer particles 22 included in the resin layer 21 and cause these fluorescer particles 22 to drop out from the resin layer 21. As a result, the recesses 21c can be made easily.

In the embodiment, many of the partially-exposed fluorescer particles 22 are forcibly caused to drop out by performing machining of the upper surface of the resin layer 21 by appropriately selecting the conditions and tools of the machining. Thereby, the anchor effect and the effect of increasing the contact surface area described above can be increased by making many recesses 21c having pot-like configurations. Further, degradation of the light emission characteristics of the semiconductor light emitting device 1 due to the fluorescer particles 22 being damaged can be suppressed because the fluorescer particles 22 that are damaged by the machining can be removed.

### (Second embodiment)

A second embodiment will now be described.

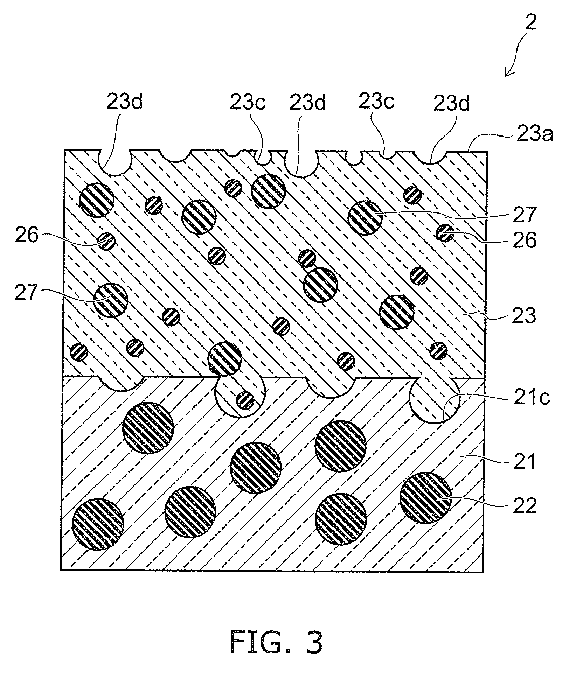

FIG. 3 is a partial cross-sectional view showing a semiconductor light emitting device according to the embodiment.

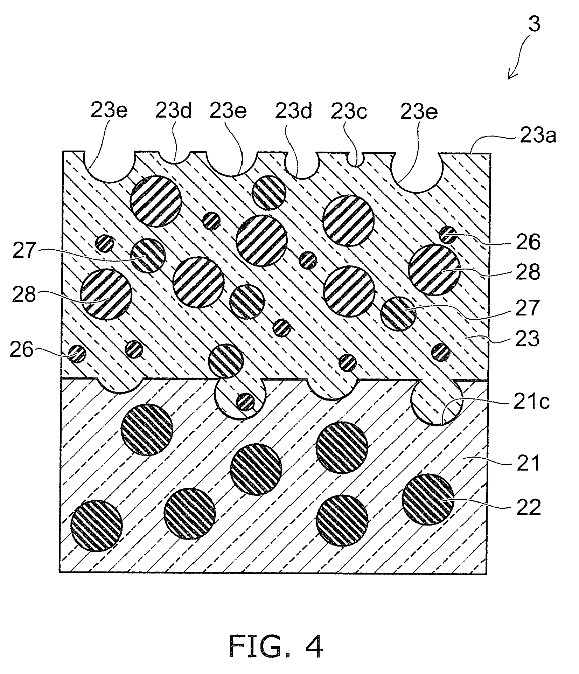

For convenience of illustration in FIG. 3, the semiconductor layer 10, the n-side electrode 11n, the p-side electrode 11p, the sealing member 12, the interconnect layers 13n and 13p, the n-side pillar 14n, the p-side pillar 14p, and the sealing member 15 are not shown. This is similar for FIG. 4 described below.

In the semiconductor light emitting device 2 according to the embodiment as shown in FIG. 3, nanoparticles 26 and micro particles 27 are provided inside the resin layer 23. The nanoparticles 26 are particles for selectively reflecting or scattering the light. The diameters of the nanoparticles 26 are smaller than those of the fluorescer particles 22, e.g., 100 nm or less. The nanoparticles 26 are formed of, for example, a metal oxide such as silicon oxide, aluminum oxide, titanium oxide, etc. Moreover, the nanoparticles 26 may be a void.

The micro particles 27 are particles for making the recesses in the upper surface of the resin layer 23. The diameters of the micro particles 27 are about the same as the wavelength of the light emitted by the semiconductor layer 10 or the wavelength of the light emitted by the fluorescer particles 22, e.g., about several hundred nm. Also, in the embodiment, recesses 23c and 23d are made in an upper surface 23a of the resin layer 23. The sizes of the recesses 23c are about the same as the sizes of the nanoparticles 26; and the sizes of the recesses 23d are about the same as the sizes of the micro particles 27. Otherwise, the effects of the embodiment are similar to those of the first embodiment described above.

In the embodiment, the resin layer 23 is formed by coating a resin material that includes the nanoparticles 26 and the micro particles 27. Then, the recesses 23c and 23d are made in the upper surface 23a by exposing some of the nanoparticles 26 and some of the micro particles 27 at the upper surface 23a of the resin layer 23 and causing these particles to drop out when the upper surface 23a of the resin layer 23 is machined to adjust the thickness of the resin layer 23. Otherwise, the manufacturing method of the embodiment is similar to that of the first embodiment described above.

According to the embodiment, the recesses 23d can be made in the upper surface 23a of the resin layer 23 by the micro particles 27 being contained in the resin layer 23. Then, the sizes of the recesses 23d can be controlled by selecting the sizes of the micro particles 27. Thereby, recesses of any size can be made in the upper surface 23a; and the light extraction efficiency can be increased. Otherwise, the operations and the effects of the embodiment are similar to those of the first embodiment described above.

The nanoparticles 26 also may be dispersed in the resin layer 21. In such a case, it is favorable for the particle count density of the nanoparticles 26 inside the resin layer 23 to be higher than the particle count density of the nanoparticles 26 inside the resin layer 21.

### (Third embodiment)

A third embodiment will now be described.

FIG. 4 is a partial cross-sectional view showing a semiconductor light emitting device according to the embodiment.

In the semiconductor light emitting device 3 according to the embodiment as shown in FIG. 4, fluorescer particles 28 are provided inside the resin layer 23 in addition to the configuration of the semiconductor light emitting device 2 (referring to FIG. 3) according to the second embodiment described above. The fluorescer particles 28 absorb the light emitted from the semiconductor layer 10 and emit light of a wavelength that is different from that of the light emitted by the semiconductor layer 10 and different from that of the light emitted by the fluorescer particles 22. For example, the wavelength of the light emitted by the fluorescer particles 28 is longer than the wavelength of the light emitted by the semiconductor layer 10 and shorter than the wavelength of the light emitted by the fluorescer particles 22.

In an example, the semiconductor layer 10 emits blue light; the fluorescer particles 22 emit red light; and the fluorescer particles 28 emit green light. In addition to the recesses 23c and 23d, recesses 23e which are where the fluorescer particles 28 dropped out are made in the upper surface 23a of the resin layer 23. Otherwise, the configuration, the manufacturing method, the operations, and the effects of the embodiment are similar to those of the second embodiment described above.

### (Fourth embodiment)

A fourth embodiment will now be described.

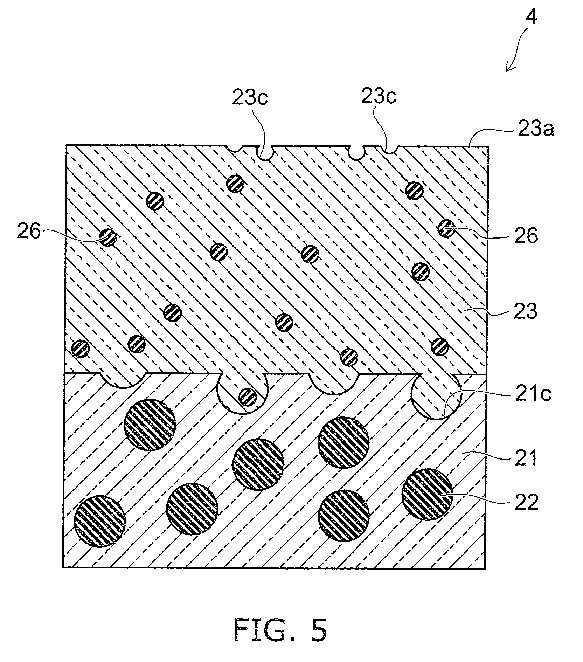

FIG. 5 is a partial cross-sectional view showing a semiconductor light emitting device according to the embodiment.

As shown in FIG. 5, the semiconductor light emitting device 4 according to the embodiment differs from the semiconductor light emitting device 2 (referring to FIG. 3) according to the second embodiment described above in that the micro particles 27 are not provided. In other words, only the nanoparticles 26 are included inside the resin layer 23. Therefore, the recesses 23d are not made in the upper surface 23a of the resin layer 23. Otherwise, the configuration, the manufacturing method, the operations, and the effects of the embodiment are similar to those of the second embodiment described above.

### (Fifth embodiment)

A fifth embodiment will now be described.

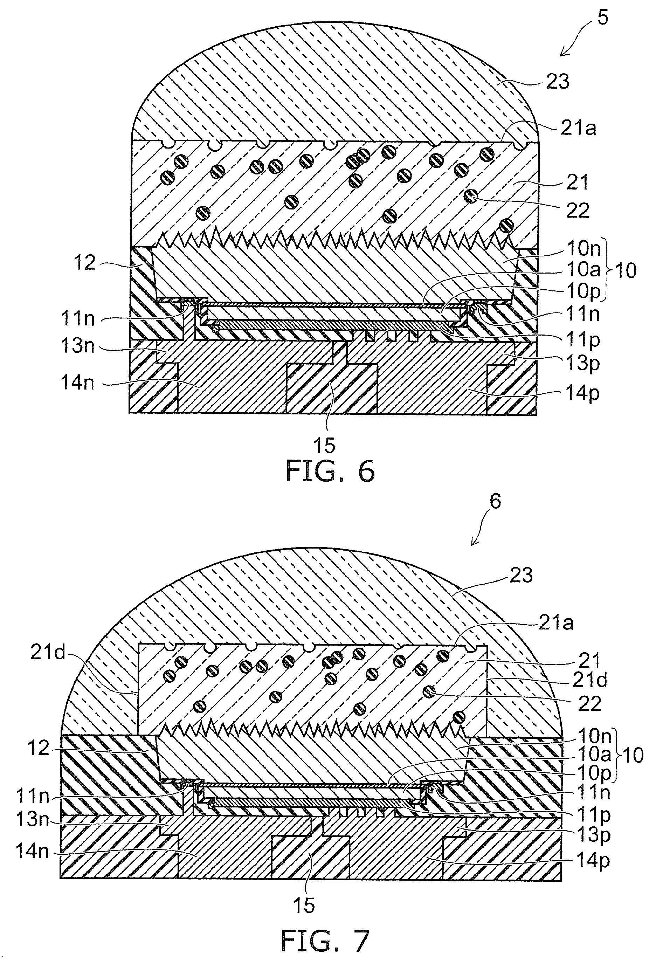

FIG. 6 is a cross-sectional view showing a semiconductor light emitting device according to the embodiment.

As shown in FIG. 6, the semiconductor light emitting device 5 according to the embodiment differs from the semiconductor light emitting device 1 (referring to FIG. 1A) according to the first embodiment described above in that the resin layer 23 of the upper layer has a lens configuration. The configuration of the resin layer 23 is, for example, a portion of a sphere.

In the embodiment, the light that is emitted from the upper surface 21a of the resin layer 21 can be concentrated toward the upward perpendicular direction by the resin layer 23 having the lens configuration. Thereby, the directivity of the light emitted by the semiconductor light emitting device 4 improves. Otherwise, the configuration, the manufacturing method, the operations, and the effects of the embodiment are similar to those of the first embodiment described above.

### (Sixth embodiment)

A sixth embodiment will now be described.

FIG. 7 is a cross-sectional view showing a semiconductor light emitting device according to the embodiment.

As shown in FIG. 7, the semiconductor light emitting device 6 according to the embodiment differs from the semiconductor light emitting device 1 (referring to FIG. 1A) according to the first embodiment described above in that the resin layer 23 is provided to cover the upper surface 21a and a side surface 21d of the resin layer 21; and the resin layer 23 has a lens configuration.

In the embodiment, by forming the resin layer 23 in a lens configuration covering the upper surface 21a and the side surface 21d of the resin layer 21, the light that is emitted from the side surface 21d of the resin layer 21 as well as the light that is emitted from the upper surface 21a of the resin layer 21 can pass through the resin layer 23 such that its chromaticity is adjusted and can be concentrated toward the upward perpendicular direction. Thereby, the directivity of the light emitted by the semiconductor light emitting device 5 improves; and the light extraction efficiency increases. Otherwise, the configuration, the manufacturing method, the operations, and the effects of the embodiment are similar to those of the first embodiment described above.

Although an example is illustrated in the embodiments described above in which machining is performed as the means for removing the upper portions of the resin layers 21 and 23, this is not limited thereto. For example, the upper portions of the resin layers 21 and 23 may be removed by dry etching. In such a case, for example, after etching the resin layer, the exposed fluorescer particles, etc., can be caused to drop out by performing brush grinding while supplying carbonated water to prevent charge buildup.

Moreover, in the embodiments described above, an adhesion layer may be provided between the semiconductor layer 10 and the resin layer 21 to improve adhesion between them. The adhesion layer may be an inorganic layer, for example, a silicon oxide layer, a silicon nitride layer or a silicon oxynitride layer and so on.

According to the embodiments described above, a semiconductor light emitting device and a method for manufacturing the semiconductor light emitting device having high reliability can be realized.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention. Additionally, the embodiments described above can be combined mutually.

## Claims

1. A semiconductor light emitting device (1, 2, 3, 4, 5, 6), comprising:
a semiconductor layer (10);
a first resin layer (21) provided on the semiconductor layer (10);
first fluorescer particles (22) disposed in the first resin layer (21); and
a second resin layer (23) provided on the first resin layer (21) to contact the first resin layer (21),
recesses (21c) being made in a surface (21a) of the first resin layer (21) contacting the second resin layer (23),
the recesses (21c) being filled with portions of the second resin layer (23).

2. The device (1, 2, 3, 4, 5, 6) according to claim 1, wherein a maximum diameter is larger than a diameter of an opening for some of the recesses (21c).

3. The device (3) according to claim 1 or 2, further comprising second fluorescer particles (28) disposed in the second resin layer (23).

4. The device (2, 3) according to claim 1, 2 or 3 further comprising a micro particle (27) disposed in the second resin layer (23), a recess (23d) being made in an upper surface (23a) of the second resin layer (23), a size of the recess (23d) being about the same as a size of the micro particle (27).

5. The device (1, 2, 3, 4, 5, 6) according to any one of the preceding claims, wherein size of the recesses (21c) are about the same as size of the first fluorescer particles (22).

6. The device (1, 2, 3, 4, 5, 6) according to any one of the preceding claims, wherein size of the recesses (21c) are within the range of a distribution of diameters of the first fluorescer particles (22).

7. The device (1, 2, 3, 4, 5, 6) according to any one of the preceding claims, wherein the recesses (21c) are made by the first fluorescer particles (22) being removed from an upper surface (21a) of the first resin layer (21).

8. The device (1, 2, 3, 4, 5, 6) according to any one of the preceding claims, wherein the semiconductor layer (10) includes a p-type layer (10p) and an n-type layer (10n),
the device (1, 2, 3, 4, 5, 6) further comprising:
a p-side electrode (11p) located under the semiconductor layer (10) and connected to the p-type layer (10p);
a p-side extraction electrode (13p+14p) located under the p-side electrode (11p) and connected to the p-side electrode (11p);
an n-side electrode (11n) located under the semiconductor layer (10) and connected to the n-type layer (10n);
an n-side extraction electrode (13n+14n) located under the n-side electrode (11n) and connected to the n-side electrode (11n); and
an insulating film (12+15) located laterally and under the semiconductor layer (10).

9. The device (1, 2, 3, 4, 5, 6) according to claim 8, wherein the p-side extraction electrode (13p+14p) includes:
a p-side interconnect layer (13p); and
a p-side pillar (14p) connected to the p-side interconnect layer (13p), and
the n-side extraction electrode (13n+14n) includes:
an n-side interconnect layer (13n); and
an n-side pillar (14n) connected to the n-side interconnect layer (13n).

10. The device (1, 2, 3, 4, 5, 6) according to claim 8, wherein one of the p-side electrode (11p) and the n-side electrode (11n) is connected to a non-emitting region of the semiconductor layer (10).

11. The device (1, 2, 3, 4, 5, 6) according to claim 9, wherein a lower surface of the p-side pillar (14p) and a lower surface of the n-side pillar (14n) are substantially coplanar with a lower surface of the insulating film (12+15).

12. The device (1, 2, 3, 4, 5, 6) according to claim 8, wherein the insulating film (12+15) includes:
a first portion located lower than the lower surface of the semiconductor layer (10) and supporting the semiconductor layer (10) with the n-side extraction electrode (13n+14n) and the p-side extraction electrode (13p+14p); and
a second portion located upper than the lower surface of the semiconductor layer (10) and surrounding a periphery of the semiconductor layer (10).

13. The device (1, 2, 3, 4, 5, 6) according to claim 8, wherein one of the p-side extraction electrode (13p+14p) and the n-side extraction electrode (13n+14n) is connected to a non-emitting region of the semiconductor layer (10) and extends to a light emitting region side of the semiconductor layer (10).

14. The device (1, 2, 3, 4, 5, 6) according to any one of the preceding claims, wherein emission light from the semiconductor layer (10) is emitted primarily from an upper surface of the semiconductor layer (10).

15. The device (1, 2, 3, 4, 5, 6) according to any one of the preceding claims, wherein the device has a wafer-level package structure.

16. The device (1, 2, 3, 4, 5, 6) according to any one of the preceding claims, wherein the semiconductor layer (10) is crystal-grown on a substrate.

17. The device (1, 2, 3, 4, 5, 6) according to claim 8, wherein the insulating film (12+15) supports the semiconductor layer (10) with the n-side extraction electrode (13n+14n) and the p-side extraction electrode (13p+14p).

18. A method for manufacturing a semiconductor light emitting device (1, 2, 3, 4, 5, 6), comprising:
forming a first resin layer (21) on a semiconductor layer (10), the first resin layer (21) including first fluorescer particles (22);
making recesses (21c) by removing an upper portion of the first resin layer (21) to cause some of the first fluorescer particles (22) to drop out from the first resin layer (21); and
forming a second resin layer (23) on the first resin layer (21), portions of the second resin layer (23) entering the recesses (21c).

19. The method according to claim 18, wherein the removing of the upper portion of the first resin layer (21) is performed by polishing an upper surface (21a) of the first resin layer (21).

20. The method according to claim 18, further comprising removing an upper portion of the second resin layer (23),
a micro particle (27) being contained in the second resin layer (23).
